# EUROPEAN PATENT SPECIFICATION

(11) **EP 0 513 590 B1**
(45) Date of publication and mention of the grant of the patent: **24.07.1996**
(21) Application number: 92107317.7
(22) Date of filing: 29.04.1992
(51) Int. Cl.: H01L 29/772, H01L 21/336

(54) **Thin-film transistor and method for manufacturing it**
Dünnfilmtransistor und Verfahren zu seiner Herstellung
Transistor en couche mince et procédé pour sa fabrication

(30) Priority: 08.05.1991 JP 102668/91; 17.10.1991 JP 269675/91
(43) Date of publication of application: 19.11.1992
(73) Proprietor: SEIKO EPSON CORPORATION, Shinjuku-ku Tokyo-to (JP)
(72) Inventor: Nakazawa, Takashi, Suwa-shi, Nagano-ken (JP)
(74) Representative: Hoffmann, Eckart, Dipl.-Ing.

(56) References cited:
- DE-A- 3 239 679
- PATENT ABSTRACTS OF JAPAN vol. 013, no. 468 (E-834)23 October 1989 &JP-A-11 83 853
- PATENT ABSTRACTS OF JAPAN vol. 014, no. 282 (E-0942)19 June 1990 &JP-A-20 90 683
- PATENT ABSTRACTS OF JAPAN vol. 10, no. 285 (E-441)(2341) 27 September 1986 &JP-A-61 105 873
- PATENT ABSTRACTS OF JAPAN vol. 015, no. 098 (E-1042)8 March 1991 & JP-A- 23 07 273
- PATENT ABSTRACTS OF JAPAN vol. 004, no. 052 (E-007)18 April 1980 &JP-A-55 024 420
- PATENT ABSTRACTS OF JAPAN vol. 006, no. 170 (E-128)3 September 1982&JP-A-57 087 175
- RESEARCH DISCLOSURE no. 325, May 1991, HAVANT GB page 369 , XP229725 'ENHANCED ADHESION TO GLASS SUBSTRATES USING TANTALUM OXIDE ADHESION LAYER'

## Description

The present invention relates to a thin-film transistor which is employed, for example, for active matrix type liquid crystal displays or memory integrated circuits.

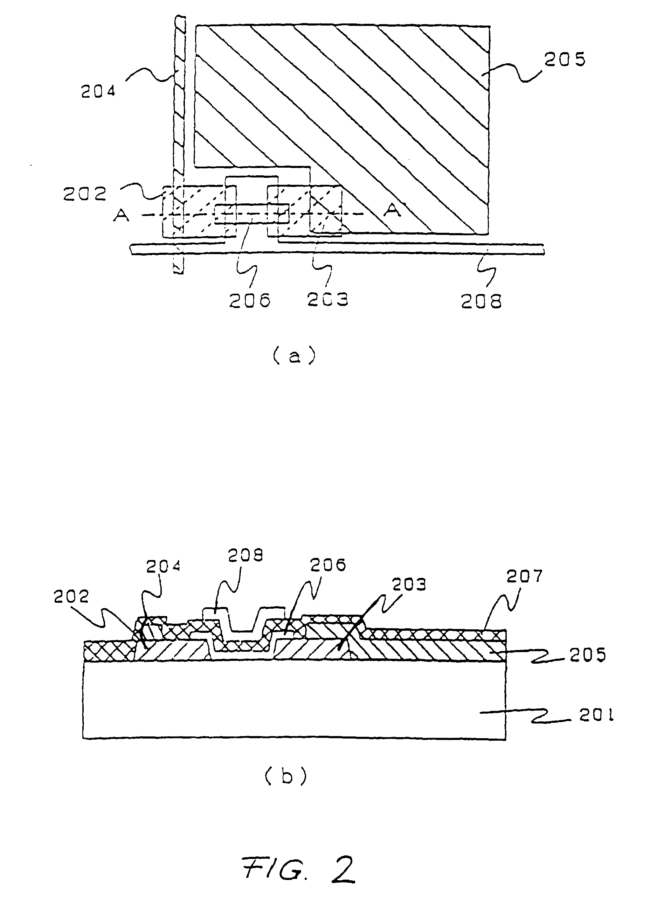

In the document "JAPAN DISPLAY" 86, 1986 pages 196 to 199, a structure of a conventional thin-film transistor is disclosed. A plan view and a sectional view of this known structure are schematically shown in Figs. 2(a) and (b), respectively. The sectional view of Fig. 2(b) is taken along the line A-A in Fig. 2(a). This thin-film transistor comprises on an insulating substrate 201 made of glass, quartz or sapphire, a source region 202 and a drain region 203 which are polysilicon thin films doped with donor or acceptor impurities. A data line 204 and a pixel electrode 205 are in contact with the source region 202 and the drain region 203, respectively. A semiconductor layer 206 which is a polysilicon thin-film is in contact with both the upper surface of the source region 202 and that of the drain region 203, and extends between these regions 202 and 203. A gate insulating film 207 covers all of these components and a gate electrode 208 is provided on the gate insulating film 207.

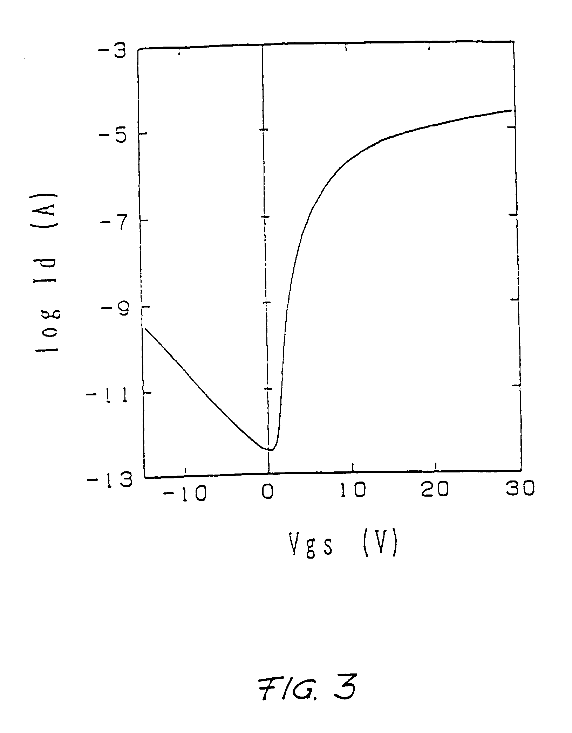

This conventional thin-film transistor suffers from problems that will be explained with reference to Fig. 3.

Fig. 3 is a graph showing the characteristic of drain current Id against gate voltage Vgs of a thin-film transistor structured as explained with reference to Fig. 2. In Fig. 3, the abscissa represents the gate voltage Vgs and the ordinate represents the logarithm of the drain current Id. The characteristic shown is that of an N type thin-film transistor whose channel length and channel width are both 10 µm and which has a voltage of 4 V applied between source and drain. The drain current Id which flows when the gate voltage Vgs is negative is designated as I_{OFF}, and the drain current Id which flows in the gate voltage Vgs is positive if designated as I_{ON}. With a polysilicon thin-film transistor the drain current Id is minimum when the gate voltage Vgs is around 0 V. At a negative gate voltage Vgs a Hall current flows increasing I_{OFF} and, thus, greatly reducing the ratio I_{ON}/I_{OFF}. Hence, when such thin-film transistor is applied to an active matrix type liquid crystal display in which the gate voltage is decreased to a negative value when electric charges accumulated in the liquid crystal layer are held, sufficient holding of the electric charges is difficult whereby the image quality of the liquid crystal display is deteriorated.

The document JP-A-1183853/1989 discloses a thin-film transistor and a method of manufacturing it. On an amorphous silicon thin film formed on an insulating substrate, a gate insulating film, a metal gate electrode and a protective insulating film are laminated in this order. The laminated films are subsequently etched away except for a gate forming region. The exposed side faces of the gate electrode are then anodized to form metal oxide insulating layers. Drain and source regions are laterally offset and do not overlap the gate electrode. The offset is equal to thickness of said metal oxide films.

The document JP-A-61105873/1986 discloses a transistor and a method of manufacturing it. A gate electrode is formed over a gate oxide film on a substrate. After thermal oxidation a first ion implantation is carried out using the gate electrode as a mask. Subsequently wet and dry thermal oxidation is carried out resulting in thick oxide films on the periphery of the gate electrode. A second ion implantation with a higher dose is performed using the gate electrode and the thick oxide films as a mask. Lightly and heavily doped regions are thus formed in the substrate, the heavily doped regions laterally offset from and not overlapping the gate electrode.

The document JP-A-2090683/1990 discloses a thin-film transistor and a method of manufacturing it. Drain and source regions of the thin-film transistor are laterally offset and do not overlap the gate electrode. This acchieved by ion impantation using a photoresist as a mask.

The present invention is intended to overcome the above explained problem of conventional thin-film transistors, and its object is to provide a thin-film transistor exhibiting a large I_{ON}/I_{OFF} ratio. An object of the invention is further to provide a method for manufacturing such thin-film transistor.

These objects are achieved with a thin-film transistor according to claim 1 and a method according to claims 6 and 7, respectively. Preferred embodiments of the invention are subject matter of dependent claims.

As will be better understood from the following detailed description of various embodiments of the present invention, specific advantages achieved by the invention are as follows:

By providing an accurately controllable offset between the gate electrode and each of source and drain regions, a thin-film transistor having a sufficiently low I_{OFF} can be provided.

Application of the thin-film transistor according to the present invention to an active matrix display of an EL or DDLC type which requires a high drive voltage, provides a plane display having an excellent display quality.

Application of the thin-film transistor according to the present invention to an active matrix type liquid crystal display greatly reduces short circuit defects and, thus, provides a liquid crystal display having an excellent display quality.

Since a simple process of anodic oxidation allows for an accurate control of the said offset, the equipment for manufacturing the thin-film transistor is not costly and so the production cost of a liquid crystal display is decreased.

Preferred embodiments of the present invention will be described below with reference to the drawings, in which:
- Fig. 1: is a cross-sectional view of a thin-film transistor according to one embodiment of the present invention, taken in the direction of channel length,
- Figs. 2(a) and (b): are a plan view and a cross-sectional view, respectively, illustrating the structure of a conventional thin-film transistor, the cross-secof Fig. 2(b) being taken along the line A-A in Fig. 2(a),
- Fig. 3: is a graph showing a characteristic of the conventional thin-film transistor,
- Fig. 4: is a graph showing how the film thickness of tantalum oxide changes with changes of the voltage in anodic oxidation of tantalum,
- Fig. 5: is a graph showing a characteristic corresponding to that of Fig. 3 of a thin-film transistor according to the present invention,
- Figs. 6(a), (b) and (c): are a plan view, a cross-sectional view taken along line A-A' in Fig. 6(a) and a cross-sectional view taken along line B-B' in Fig. 6(a), respectively, illustrating an active matrix type liquid crystal display substrate to which the thin-film transistor according to the present invention can be applied,
- Figs. 7(a) and (b): show an equivalent circuit of the active matrix type liquid crystal display and a drive signal waveform, respectively,
- Figs 8(a), (b) and (c): are cross sectional views showing different manufacturing steps of a thin-film transistor according to another embodiment of the present invention, and
- Fig. 9: is a graph showing how the film thickness of tantalum oxide changes with changes of the voltage in an anodic oxidation of tantalum.

### FIRST EMBODIMENT

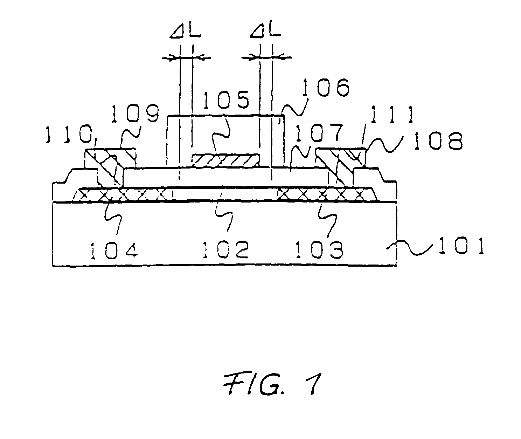

Fig. 1 is a cross-sectional view of a thin-film transistor according to a first embodiment of the present invention. The section is taken in the direction of the transistor's channel length.

On a substrate 101 made of glass, quartz, a ceramic or silicon there is formed a 25 nm thick polysilicon layer. This polysilicon layer comprises a portion 102 forming the transistor's channel region, a portion 104 forming its source region and a portion 103 forming its drain region. The polysilicon layer is preferably formed by decomposing monosilane gas in an atmosphere of 600°C by low-pressure CVD. However, formation of the polysilicon layer is not limited to the low-pressure CVD technique. Instead, the polysilicon layer may also be formed by first forming amorphous silicon by sputtering or plasma CVD which is then heat treated at a temperature ranging from 550°C to 600°C for 5 to 40 hours to convert the amorphous silicon to polysilicon. Amorphous silicon may further be made to polysilicon by irradiating it using an argon or excimer laser.

Next, a gate insulating film 107 of SiO₂ is formed to a thickness of 150 nm by ECR plasma CVD. ECR plasma CVD assures formation of fine SiO₂ having less traps at a low temperature of 100°C or below and is optimal as the gate insulating film manufacturing method. The gate insulating film 107 may also be formed by thermally oxidizing the surface of the polysilicon layer (102, 103 and 104) in a oxygen atmosphere of 1100°C.

On the gate insulating film 107 a 400nm thick gate electrode 105 of tantalum is formed by sputtering. Using this gate electrode 105 as a mask, phosphorus ions are then implanted planted into the polysilicon through the gate insulating film 107 at a dose of 3 x 10¹⁵ cm⁻² and an energy level of 120 keV so as to form the source region 104 and the drain region 103 in a self-alined manner. If phosphorus ions are implanted by the ion implantation, an N type thin-film transistor will be obtained. Implantation of boron ions provides a P type thin-film transistor. If the type of implanted ions is selectively changed using a photoresist or the like, a CMOS type inverter circuit can be readily obtained.

After implantation, the implanted phosphorus ions are irradiated by an argon or excimer laser and thereby activated to reduce the resistance of the polysilicon in the source region 104 and the drain region 103.

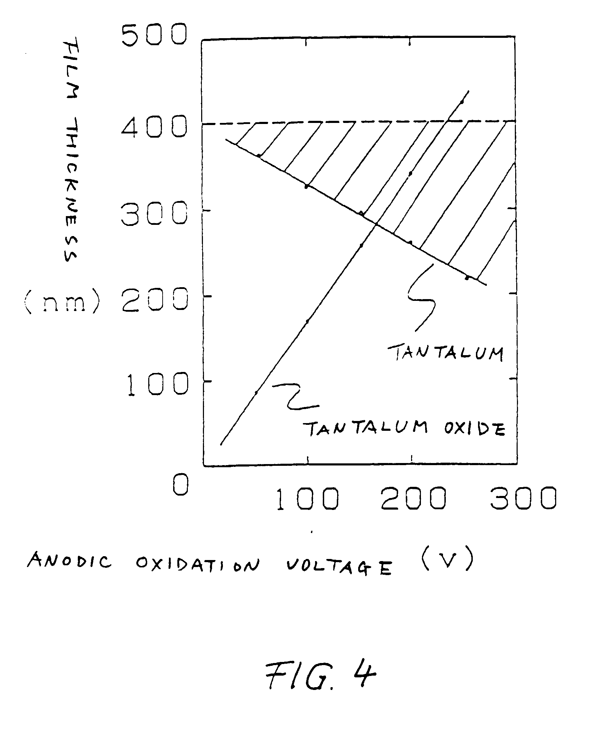

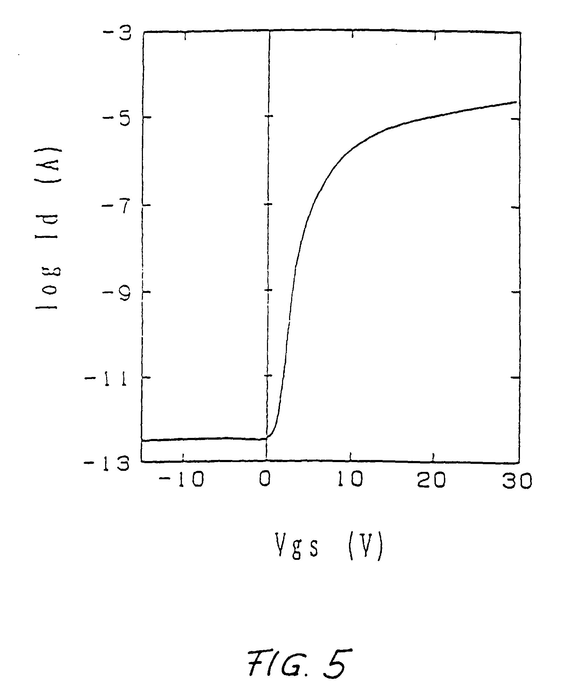

Subsequently, an insulator 106 of tantalum oxide is formed on the surface of the gate electrode 105 by anodic oxidation. Fig. 4 illustrates how the thickness of the tantalum oxide and the tantalum, respectively, changes with changes of the voltage used for anodic oxidation. In Fig. 4, the abscissa represents the voltage and the ordinate the film thickness. As shown in Fig. 4, the film thickness of tantalum oxide increases in proportion to the anodic oxidation voltage. The film thickness can be controlled at a rate of 1.7 to 1.8 nm/V. When tantalum is subjected to anodic oxidation, its surface is oxidized and the tantalum film thickness decreases correspondingly.

As a result of converting a surface region of the tantalum gate electrode 105 to tantalum oxide insulator 106, an offset ΔL corresponding to the film thickness indicated by a hatched portion in Fig. 4 is generated. As shown in Fig. 1, the offset ΔL means an additional distance between the edges of gate electrode 105 and the edge of each of source and drain regions 104 and 103. Anodic oxidation at a voltage of 250 V generates an offset ΔL of 200 nm. It is possible to accurately control the offset ΔL by controlling the anodic oxidation voltage. The upper limit of the anodic oxidation voltage applied to form the tantalum oxide is the highest voltage the formed tantalum oxide can resist, which is about 250 V. Hence, the offset ΔL can be controlled to any value between 0 and 200 nm.

Finally, contact holes 110 and 111 are opened in the insulating layer 107 above the source region 104 and the drain region 103, and a source interconnection 109 and a drain interconnection 108 of an alloy of aluminum and silicon are respectively provided in the contact holes 110 and 111.

The effect of the offset ΔL in the thin-film transistor described above is that the voltage between the gate electrode and the drain region and the voltage between the gate electrode and the source region, when the gate voltage Vgs is negative, can be effectively reduced.

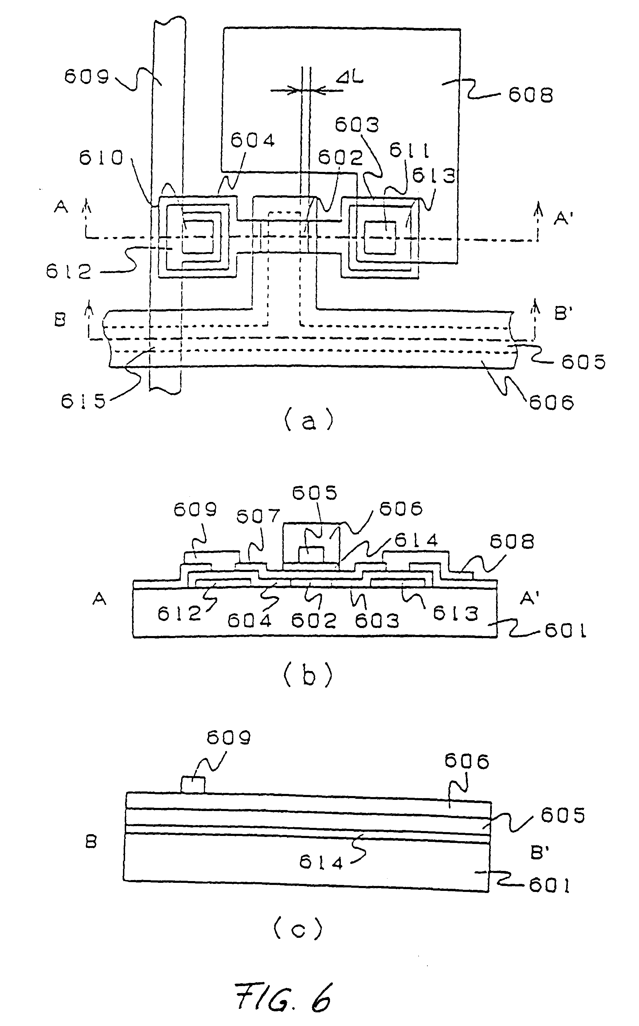

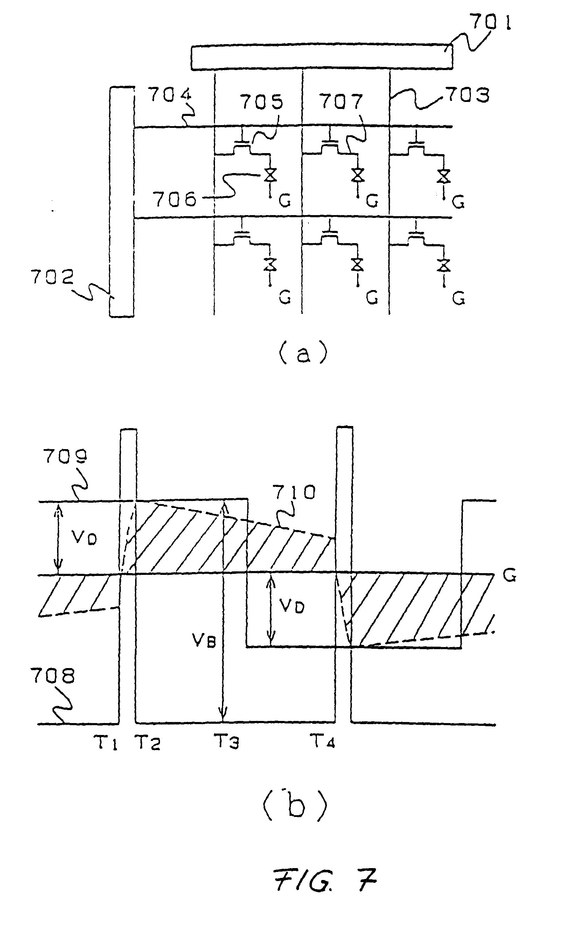

Fig. 5 shows the Id-Vgs-characteristic of a thin-film transistor whose anodic oxidation voltage is 150 V and whose offset ΔL about 100 nm. As with Fig. 3, the abscissa represents the gate voltage Vgs and the ordinate the logarithm of the drain current Id.

Comparing the characteristic of Fig. 3 corresponding to a conventional thin-film transistor with that of Fig. 5 corresponding to a thin-film transistor according to the present invention, it will be easily seen that in the characteristic of Fig. 5 the drain current Id remains substantially constant for negative values of the gate voltage up to around 0 V. That means I_{OFF} is greatly improved. I_{ON}, that is the drain current for positive gate voltages, is substantially the same as that of the conventional thin-film transistor.

In the thin-film transistor, since the polysilicon layer that forms the channel region is as thin as 25 nm, the range of a depletion layer is limited and an inversion layer is readily formed. Hence, when the offset ΔL is 200 nm or less a reduction of I_{ON} is small. When the offset ΔL is 100 nm or below, since the voltage between the gate electrode and the drain region and the voltage between the gate electrode and the source region are not reduced sufficiently, I_{OFF} can not be reduced. Therefore, the obtimum value for the offset is between 100 and 200 nm and the obtimum anodic oxidation voltage is between 150 and 250 V. Since the anodic oxidation assures excellent reproduction and uniform oxidation over a large area, the thin-film transistor according to the present invention can be advantageously applied to an active matrix type liquid crystal display.

In the embodiment described above, the gate electrode is formed of tantalum. However, it may be formed of any metal which is capable of forming an oxide by anodic oxidation, such as aluminum or niobium.

### SECOND EMBODIMENT

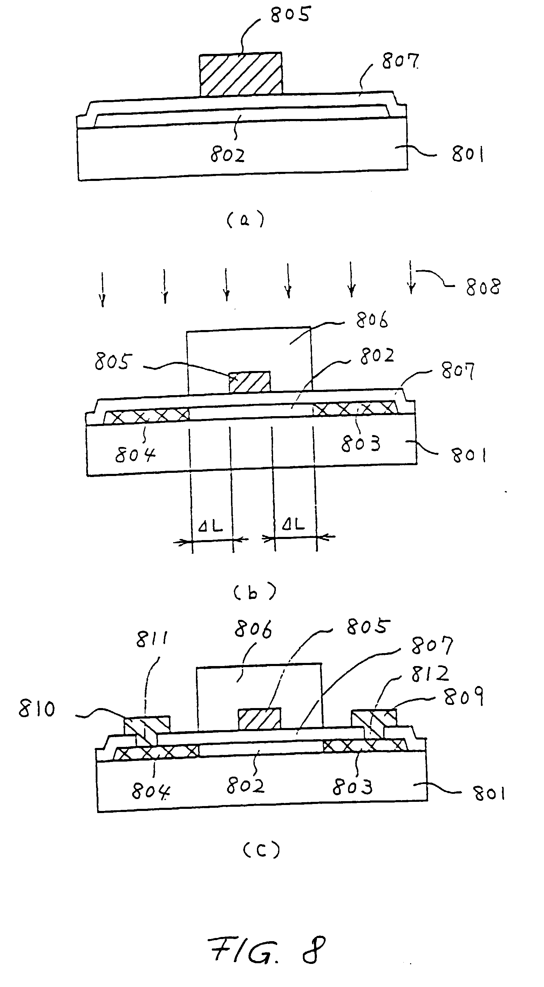

Fig. 6 shows a thin-film transistor according to an embodiment of the present invention applied to an active matrix type liquid crystal display substrate. Fig. 6(a) is a plan view of the active matrix type liquid crystal display substrate. Fig. 6(b) is a sectional view of a thin-film transistor portion taken along line A-A' of Fig. 6(a). Fig. 6(c) is a sectional view taken along line B-B' of Fig. 6(a).

Silicon thin-films 612 and 613 are formed on a glass substrate 601 made of NA 35 manufactured by Hoya Corporation. These silicon thin films may be amorphous silicon thin films formed by plasma CVD or polysilicon thin films formed by low-pressure CVD. A desired thickness of these films is between 50 and 200 nm.

Next, a semiconductor layer 602 acting as a channel region of the thin-film transistor, a source region 604 and a drain region 603 are formed as in the case of the first embodiment. Then a gate insulating film 607 of SiO₂ is formed in contact with these layers. A desired thickness of the semiconductor layers 602, 603 and 604 is between 20 and 50 nm.

Thereafter, a first insulator 614 of tantalum oxide and a gate electrode 605 of tantalum are formed. The first insulating film 614 is formed in a atmosphere of argon gas or a mixture gas of argon gas and oxygen gas by RF sputtering using tantalum oxide targets. The thickness of the first insulating film 614 is from 20 to 50 nm. Subsequently, the gate electrode 605 is formed at a thickness of 400 nm by DC sputtering. The first insulator 614 and the gate electrode 605 are then processed using a photolithographic or dry etching technique.

The dry etching device used to process the gate electrode 605 and the first insulator 614 includes a plasma chamber in which a mixture gas of freon gas and oxygen gas is decomposed by plasma discharge to generate radicals which contribute to etching, and an etching chamber where etching takes place using the radicals generated in the plasma chamber and conveyed thereto. The etch rate of tantalum and that of tantalum oxide are substantially the same, and the etch rate of SiO₂ is 1/20th of that of tantalum oxide or less.

Using such dry etching device, etching of the gate electrode 605 and the first insulator 614 is continuously conducted until the SiO₂ gate insulating film 607 is completely exposed. Thus, only the portion of the first insulator 614 located below the gate electrode 605 is left. This remaining portion of the first insulator serves to improve the adhesion between the gate insulating film 607 and the gate electrode 605 to thereby enhance the reliability.

Next, phosphorus ions are implanted into the silicon layers 603, 604, 612 and 613 through the gate insulating film 607 by ion implantation so as to form the source region and the drain region in a self-aligned fashion, as in the case of the first embodiment.

Subsequently, a 420 nm thick second insulator 606 of tantalum oxide is formed on the gate electrode 605 by subjecting the surface of the latter anodic oxidation in a solution of 0.01 wt% of citric acid at an anodic oxidation voltage of 250 V, thereby obtaining an offset ΔL of about 200 nm.

Next, the previously implanted phosphorus ions are activated by laser irradiation as in the case of the first embodiment. Thereafter, the gate insulating film 607 is etched using a mixture liquid of hydrofluoric acid and ammonium fluoride to open contact holes 610 and 611, and then a pixel electrode 608 of ITO (indium tin oxide) is formed to a thickness of 30 to 50 nm.

Finally, a data line 609 of an alloy of aluminum and silicon is provided.

In the active matrix substrate arranged as explained above, insulation between data line 609 and gate electrode 605 that cross each other (at 615 in Fig. 6(a)), is provided by the second insulator 606 making it unnecessary to provide an extra insulating film.

Tantalum oxide formed by anodic oxidation is fine and has little defects such as pin holes, only. Consequently, the danger of short circuit defects between data line 609 and gate electrode 605 is substantially reduced.

When a voltage is applied to tantalum oxide, a Poole-Frenkel conduction current flows in the tantalum oxide that exhibits a current-voltage-characteristic having a threshold voltage. However, since the tantalum oxide of the second insulating film 606 is as thick as 420 nm and the threshold voltage is sufficiently higher than the voltage of 20 to 30 V at which the active matrix substrate as generally driven, a resistance as high as 10¹⁵ Ω is obtained and no problem caused. When the offset ΔL is 100 nm, the thickness of the tantalum oxide must be reduced to 250 nm. However, even in this case, problems do not occur.

As shown in Fig. 6(b), the gate insulating film 607 of SiO₂ and the first insulator 614 of tantalum oxide are present between the gate electrode 605 and the semiconductor layer 602. However, since the dielectric constant of tantalum oxide is large, namely between 25 and 28, the electric characteristics of the thin-film transistor are not substantially affected. Rather, the two-insulating layer structure reduces the danger of any short circuit defects between the gate electrode 605 and the semiconductor layer 602.

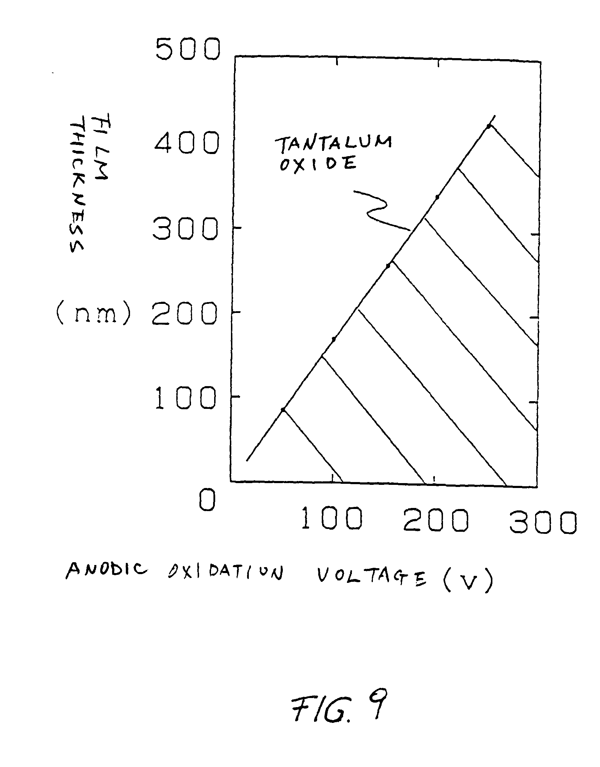

Fig. 7(a) shows an equivalent circuit of the active matrix type liquid crystal display. Fig. 7(b) shows a drive signal waveform for the active matrix type liquid crystal display. In Fig. 7(a), reference numeral 701 denotes a hold circuit and 702 a scanning circuit. A thin-film transistor 705 is provided at each matrix point where a data line 703 crosses a gate electrode 704. A liquid crystal layer 706 is provided between a respective pixel electrode connected to the drain region 707 of each thin-film transistor and a common electrode G. A gate signal 708 shown in Fig. 7(b) is applied to the gate electrode 704 to turn on thin-film transistor 705 connected thereto in an interval from T1 to T2. A data signal 709 applied to a data line 703 is thereby written through the respective thin-film transistor into the liquid crystal layer 706. During an interval from T2 to T4 the thin-film transistor 705 is turned off to hold the electric charge written into the liquid crystal layer 706. During this off time the voltage of the drain region 707 changes as indicated by 710 in Fig. 7(b), and an effective voltage indicated by a hatched portion is applied to the liquid crystal layer 706. At time T3 a negative bias corresponding to -VB relative to the potential on data line 703 is applied to the gate electrode. If a twist nematic liquid crystal is used for the liquid crystal layer 706, a voltage VD of 1 to 5 V is necessary. This reduces VB to 10 to 12 V and the gate voltage Vgs to -10 to -12 V. Therefore, a sufficiently low I_{OFF} is required.

As will be appreciated from Fig. 5, the thin-film transistor according to the present invention provides a sufficiently low I_{OFF} and, thus, enables the electric charge written into the liquid crystal layer to be stably held. Therefore, a liquid crystal display having a large contrast and an excellent visual angle can be provided.

### THIRD EMBODIMENT

A thin-film transistor according to a third embodiment of the present invention will be explained with reference to Fig. 8.

As shown in Fig. 8(a), a polysilicon semiconductor layer 802, an SiO₂ gate insulating film 807 and a tantalum gate electrode 805 are formed in this order on a substrate 801, as in the case of the first embodiment.

Next, as shown in Fig. 8(b), the surface of the gate electrode 805 is subjected to oxidation by anodic oxidation to form an insulator 806 of tantalum oxide. After that phosphorus ions 808 are implanted into the semiconductor layer 802 through the gate insulating film 807 by ion implantation or high-energy ion doping so as to form a source region 804 and a drain region 803 in a self-aligned fashion. Fig. 9 shows the relation between the anodic oxidation voltage of tantalum and the film thickness of tantalum oxide. The abscissa represents the voltage and the ordinate the film thickness. The film thickness of tantalum oxide increases in proportion to the anodic oxidation voltage. The film thickness can be controlled at a rate of 1.7 to 1.8 nm/V.

By means of the above manufacturing steps an offset ΔL shown in Fig. 8(b) and corresponding to the film thickness indicated by a hatched portion in Fig. 9 is generated. The offset ΔL can be controlled in a range from 0 to 450 nm by controlling the anodic oxidation voltage.

In the first embodiment, the anodic oxidation is conducted after implantation of impurity ions, and the offset ΔL can be accurately controlled in a range between 0 to 200 nm. In the present third embodiment, however, the order of ion implantation and anodic oxidation is reversed and the offset ΔL can be controlled in a range larger than that of the first embodiment. Therefore, when compared with the first embodiment, the voltage between the gate electrode and the drain region and the voltage between the gate electrode and the source region when the gate voltage Vgs is reduced to a negative range, can be further reduced, thus further increasing the source drain voltage Vds and further reducing I_{OFF} when the gate is negatively biased. Hence, the thin-film transistor according to the present invention can also be applied to active matrix type displays of the EL or PDLC type which require a higher drive voltage then does TN type liquid crystal display device.

The phosphorus ions after having been implanted are activated by argon or excimer laser irradiation or by ramp annealing so as to reduce the resistance of the polysilicon forming the source region 804 and the drain region 803. It is desired that this activation be conducted in a short time. Activation which requires a long time, such as heat annealing, diffuses the implanted phosphorus ions into the semiconductor layer 802 and, thus, effectively reduces the offset ΔL.

Finally, as shown in Fig. 8(c), contact holes 811 and 812 are respectively opened in gate insulating film 807 above the source region 804 and the drain region 803, and a source interconnection 810 and a drain interconnection 809 are then provided.

## Claims

1. A thin-film transistor including
a semiconductor layer (102, 103, 104) having a portion doped with impurities,
a gate insulating film (107), and
a gate electrode (105) made of metal, the surface of the gate electrode (105) being covered with an insulator (106),
wherein said insulator (106) is made of an oxide of said metal formed by subjecting the surface of the gate electrode to anodic oxidation, and said doped portion (103, 104) of the semiconductor layer is laterally offset from the gate electrode (105) not to overlap the gate electrode, the offset being no more than the thickness of said insulator (106).

2. The thin-film transistor according to claim 1, characterized in that said offset is in the range of 100 to 200 nm.

3. The thin-film transistor according to claim 1 or 2, characterized in that the gate electrode (105) is made of tantalum.

4. The thin-film transistor according to any of the preceding claims, wherein the semiconductor layer (102, 103, 104), the gate insulating film (107) and the gate electrode (105) with the surface thereof covered with said insulator (106) are formed one on top the other.

5. The thin-film transistor according to claim 4, wherein a further insulator (614) of tantalum oxide is formed between the gate insulating film (607) and the gate electrode (605).

6. A method of manufacturing a thin-film transistor as defined in claim 1 comprising the steps of:
forming a semiconductor layer (102, 103, 104), a gate insulating film (107) and a metallic gate electrode (105) in sequence,
forming a source region (104) and a drain region (103) by adding donor or acceptor impurities to the semiconductor layer in a self-alignment fashion using the gate electrode (105) as a mask, and
forming an insulator (106) by subjecting the surface of the gate electrode (105) to anodic oxidation.

7. A method of manufacturing a thin-film transistor as defined in claim 1 comprising the steps of:
forming a semiconductor layer (802), a gate insulating film (807) and a metallic gate electrode (805) in sequence,
forming an insulator (806) by subjecting the surface of the gate electrode to anodic oxidation, and
forming a source region (804) and a drain region (803) by adding donor or acceptor impurities to the semiconductor layer in a self-alignment fashion using the oxidized surface of the gate electrode as a mask.

8. The method according to claim 6 or 7, characterized in that the voltage used for anodic oxidation of the gate electrode is between 150 and 250 V.

## Patentansprüche

1. Dünnfilmtransistor, enthaltend,
eine Halbleiterschicht (102, 103, 104), die einen mit Dotierstoff dotierten Abschnitt aufweist,
einen Gateisolierfilm (107), und
eine Gateelektrode (105) aus Metall, wobei die Oberfläche der Gateelektrode (105) mit einem Isolator (106) bedeckt ist,
wobei der Isolator (106) aus einem Oxid des Metalls besteht, das dadurch gebildet ist, daß die Oberfläche der Gateelektrode einer anodischen Oxidation unterzogen ist, und der dotierte Abschnitt (103, 104) der Halbleiterschicht seitlich gegenüber der Gateelektrode (105) versetzt ist, um nicht die Gateelektrode zu überlappen, wobei der Versatz nicht mehr als die Dicke des Isolators (106) beträgt.

2. Dünnfilmtransistor nach Anspruch 1, dadurch gekennzeichnet, daß der Versatz im Bereich von 100 bis 200 nm liegt.

3. Dünnfilmtransistor nach Anspruch 1 oder 2, dadurch gekennzeichnet, daß die Gateelektrode (105) aus Tantal besteht.

4. Dünnfilmtransistor nach einem der vorhergehenden Ansprüche, bei dem die Halbleiterschicht (102, 103, 104), der Gateisolierfilm (107) und die Gateelektrode (105), deren Oberfläche mit dem Isolator (106) bedeckt ist, aufeinander ausgebildet sind.

5. Dünnfilmtransistor nach Anspruch 4, bei dem ein weiterer Isolator (614) aus Tantaloxid zwischen dem Gateisolierfilm (607) und der Gateelektrode (605) ausgebildet ist.

6. Verfahren der Herstellung eines Dünnfilmtransistors nach Anspruch 1, umfassend die Schritte:
nacheinander erfolgendes Ausbilden einer Halbleiterschicht (102, 103, 104), eines Isolierfilms (107) und einer metallischen Gateelektrode (105),
Ausbilden einer Sourcezone (104) und einer Drainzone (103) durch Zusetzen eines Donator- oder Akzeptordotierstoffs zu der Halbleiterschicht in einer Selbstausrichtungsweise unter Verwendung der Gateelektrode (105) als einer Maske, und
Ausbilden eines Isolators (106) durch Unterziehen der Oberfläche der Gateelektrode (105) einer anodischen Oxidation.

7. Verfahren der Herstellung eines Dünnfilmtransistors gemäß Anspruch 1, umfassend die Schritte:
nacheinander erfolgendes Ausbilden einer Halbleiterschicht (802), eines Gateisolierfilms (807) und einer metallischen Gateelektrode (805),
Ausbilden eines Isolators (806) durch Unterziehen der Oberfläche der Gateelektrode einer anodischen Oxidation, und
Ausbilden einer Sourcezone (804) und einer Drainzone (803) durch Zusetzen eines Donator- oder Akzeptor-Dotierstoffs zu der Halbleiterschicht in einer Selbstausrichtungsweise unter Verwendung der oxidierten Oberfläche der Gateelektrode als einer Maske.

8. Verfahren nach Anspruch 6 oder 7, dadurch gekennzeichnet, daß die zur anodischen Oxidation der Gateelektrode verwendete Spannung zwischen 150 und 250 V liegt.

## Revendications

1. Un transistor à couches minces comprenant
une couche de semiconducteur (102, 103, 104) ayant une partie dopée avec des impuretés,
une pellicule d'isolation de grille (107), et
une électrode de grille (105) consistant en métal, la surface de l'électrode de grille (105) étant recouverte d'un isolant (106),
dans lequel cet isolant (106) est constitué par un oxyde du métal précité, formé en appliquant une oxydation anodique à la surface de l'électrode de grille, et la partie dopée (103, 104) de la couche de semiconducteur est décalée latéralement par rapport à l'électrode de grille (105), de façon à ne pas chevaucher l'électrode de grille, le décalage n'étant pas supérieur à l'épaisseur de l'isolant (106).

2. Le transistor à couches minces selon la revendication 1, caractérisé en ce que le décalage est dans la plage de 100 à 200 nm.

3. Le transistor à couches minces selon la revendication 1 ou 2, caractérisé en ce que l'électrode de grille (105) consiste en tantale.

4. Le transistor à couches minces selon l'une quelconque des revendications précédentes, dans lequel la couche de semiconducteur (102, 103, 104), la pellicule d'isolation de grille (107) et l'électrode de grille (105) avec sa surface recouverte de l'isolant (106), sont formées les unes sur les autres.

5. Le transistor à couches minces selon la revendication 4, dans lequel un isolant supplémentaire (614) consistant en oxyde de tantale est formé entre la pellicule d'isolation de grille (607) et l'électrode de grille (605).

6. Un procédé de fabrication d'un transistor à couches minces défini dans la revendication 1, comprenant les étapes suivantes :
on forme successivement une couche de semiconducteur (102, 103, 104), une pellicule d'isolation de grille (107) et une électrode de grille métallique (105),
on forme une région de source (104) et une région de drain (103) en ajoutant des impuretés de type donneur ou accepteur à la couche de semiconducteur, d'une manière auto-alignée, en utilisant à titre de masque l'électrode de grille (105), et
on forme un isolant (106) en appliquant une oxydation anodique à la surface de l'électrode de grille (105).

7. Un procédé de fabrication d'un transistor à couches minces défini dans la revendication 1, comprenant les étapes suivantes :
on forme successivement une couche de semiconducteur (802), une pellicule d'isolation de grille (807) et une électrode de grille métallique (805),
on forme un isolant (806) en appliquant une oxydation anodique à la surface de l'électrode de grille, et
on forme une région de source (804) et une région de drain (803) en ajoutant des impuretés de type donneur ou accepteur à la couche de semiconducteur, d'une manière auto-alignée, en utilisant à titre de masque la surface oxydée de l'électrode de grille.

8. Le procédé de la revendication 6 ou 7, caractérisé en ce que la tension qui est utilisée pour l'oxydation anodique de l'électrode de grille est comprise entre 150 et 250 V.
